**Europäisches Patentamt**

**European Patent Office**

**Office européen des brevets**

(19)

(11) Veröffentlichungsnummer: **0 230 567**

**A1**

(12) # EUROPÄISCHE PATENTANMELDUNG

(21) Anmeldenummer: 86116745.0

(22) Anmeldetag: 02.12.86

(51) Int. Cl.4: **H01L 39/14**

(30) Priorität: 20.01.86 DE 3601492

(43) Veröffentlichungstag der Anmeldung:
05.08.87 Patentblatt 87/32

(84) Benannte Vertragsstaaten:
**CH DE FR GB IT LI**

(71) Anmelder: **VACUUMSCHMELZE GMBH**
**Grüner Weg 37 Postfach 2253**
**D-6450 Hanau 1(DE)**

(72) Erfinder: **Both, Reinhard**
**Dresdener Ring 16**
**D-6369 Nidderau 2(DE)**
Erfinder: **Hillmann, Hans, Dr.**
**Würzburger Strasse 55**
**D-6458 Rodenbach 1(DE)**
Erfinder: **Breuer, Walter**
**Am Eichenhain 29**
**D-6458 Rodenbach 1(DE)**

(54) **Verfahren Zur Herstellung eines stabilisierten Filament-Supraleiters mit hohem Anteil an Stabilisierungsmaterial.**

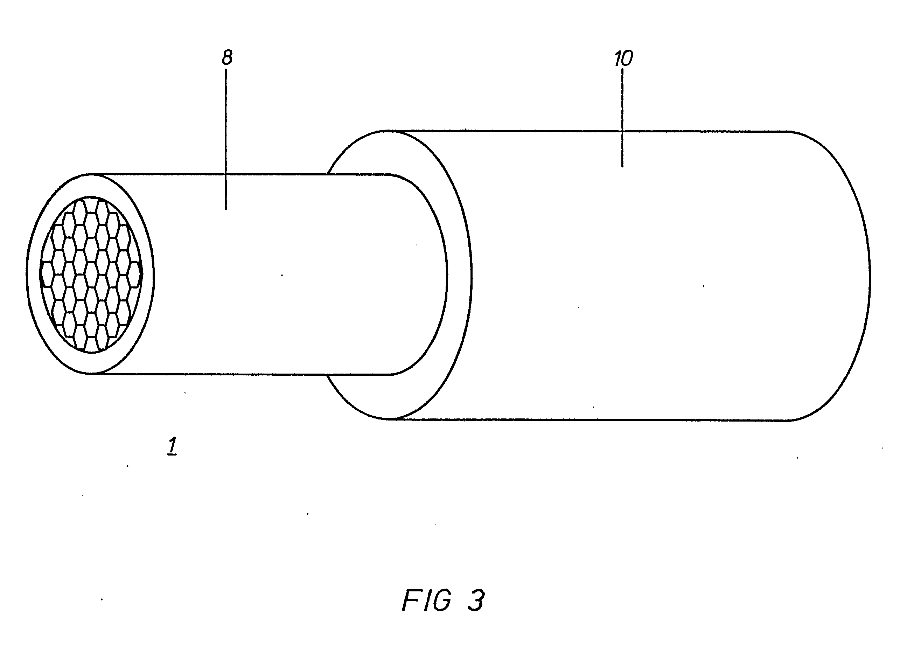

(57) Zur Herstellung von Supraleitern mit einem hohen Anteil an Stabilisierungsmaterial wird zunächst ein Verbundkörper (1) gebildet und durch Strangpressen und Ziehen querschnittsvermindernd verformt. Dieser Verbundkörper (1) wird anschließend zur Erhöhung des Anteils an Stabilisierungsmaterial in ein Hüllrohr (10) eingebracht und durch weitere Zeihvorgänge auf Endabmessung verformt. Abrisse der supraleitenden Filamente werden vermieden, indem in zentralen Bereich des Verbundkörpers ausreichend Stabilisierungsmaterial (hier z.B. Kupfer) eingesetzt wird. Hierdurch lassen sich Filament-Supraleiter mit einem hohen Anteil an Stabilisierungsmaterial preisgünstig herstellen (Figur 3).

FIG 3

## Verfahren zur Herstellung eines stabilisierten Filament-Supraleiters mit hohem Anteil an Stabilisierungsmaterial

Die Erfindung betrifft ein Verfahren zur Herstellung eines stabilisierten Filament-Supraleiters, bei dem Stäbe mit je einem Kern aus Supraleitermaterial gebündelt, mit einem Mantel aus elektrisch gut leitfähigem Stabilisierungsmaterial umgeben und der so gebildete Verbundkörper durch Strangpressen und/oder Ziehen einer querschnittsvermindernden Verformung unterzogen wird.

Ein derartiges Verfahren ist beispielsweise aus der Schweizer Patentschrift 456 790, entspricht DE-OS 1 640 506, bekanntgeworden. Hier werden sechseckige Stäbe aus Kupfer, die einen Kern aus supraleitendem Material, wie z.B. NbTi, enthalten, gebündelt und von einem rohrförmigen Kupfermantel umgeben. Das Ganze wird verschlossen und durch Strangpressen, Ziehen oder andere Verformungsarten einer querschnittsvermindernden Verformung unterzogen, bis man einen supraleitenden Draht mit dem gewünschten Außendurchmesser erhält. Beispielsweise für die Anwendung in der Medizintechnik (Kernspintomografie) werden supraleitende Magnete benötigt, bei denen der Anteil des Stabilisierungsmaterials den Querschnitt der Kerne aus supraleitendem Material bei weitem übersteigt.

Würde man einen derartigen Supraleiter auf die eingangs geschilderte Weise herstellen, so müßte man einen Preßbolzen mit relativ geringem Anteil an supraleitendem Querschnitt zusammenstellen und diesen danach durch kosten aufwendiges Strengpressen und nachfolgende Ziehvorgänge verformen. Bezogen auf den supraleitenden Querschnitt des fertigen Leiters ergeben sich damit zwangsläufig wesentlich höhere Herstellkosten verglichen mit Leitern, die einen geringeren Anteil an Stabilisierungsmaterial haben.

Aus diesem Grunde hat man zur Herstellung von Leitern mit einem Verhältnis von Stabilisierungs-zu Supraleitermaterial zwischen 10:1 und 15:1 zunächst einen Filamentsupraleiter mit verhältnismäßig geringem Anteil an Stabilisierung hergestellt, verformt und dann mit zusätzlichem Stabilisierungsmaterial versehen.

Beispielsweise ist in der DE-PS 30 45 277 eine derartige Anordnung beschrieben. Hier wird ein Verbundkörper, der supraleitende Drähte enthält, in die Nut eines stabilisierenden Metallprofiles eingelötet. Auf diese Weise wird der relativ teure Strangpreßvorgang für den Verbundkörper mit supraleitendem Material nur auf einen Teil des Gesamtquerschnitts angewendet und man erhält so wesentlich niedrigere Herstellkosten gegenüber dem eingangs genannten Verfahren. Dabei muß man in Kauf nehmen, daß man einen rechteckförmigen Supraleiter mit asymmetrisch darin angeordneten Filamenten erhält. Weiterhin ist es nicht möglich, den fertigen Supraleiter wesentlich zu erwärmen, so daß eine Isolierung mit einem unter Wärme aushärtbaren Lack nicht möglich ist. Man muß hier andere Isolierstoffe verwenden, die nicht nur teuer sind, sondern auch die Packungsdichte des verwickelten Supraleiters im fertigen Magneten verringern.

Aufgabe der vorliegenden Erfindung ist es, einen Filament-Supraleiter mit einem Anteil an Stabilisierungsmaterial zu schaffen, der den Anteil an Supraleitermaterial wesentlich (mindestens um das 5-fache) übersteigt, ohne daß bestimmte Querschnittsformen oder Lötverbindungen erforderlich sind.

Für einen Supraleiter mit nicht besonders hohem Anteil an Stabilisierungsmaterial ist aus der DE-AS 27 33 511 bekannt geworden, Supraleiterdrähte in einer Matrix bestehend aus einer Aluminiumlegierung unterzubringen und das so gebildete Bündel durch Strangpressen einer querschnittsvermindernden Verformung zu unterziehen. Nach dem Strangpressen und vor der weiteren querschnittsvermindernden Verformung, z.B. durch Ziehen, wird der Supraleiter mit einem Rohr aus einem hochreinen Aluminium-und einem Kupferrohr umhüllt und erst dann weiteren querschnittsvermindernden Verformungsschritten unterzogen. Nachdem der Leiter seinen Endquerschnitt erreicht hat, wird die aufgebrachte Kupferhülle entfernt, so daß ein Filament-Supraleiter mit hochreinem Aluminium als Stabilisierungsmaterial entsteht. Durch das Aufbringen des Aluminiums nach dem Strangpressen und durch die vorübergehende Ummantelung des Aluminiums mit einem mechanisch widerstandsfähigen Material, wie Kupfer, läßt sich erreichen, daß auch bei Verwendung von relativ weichem Aluminium ein Verbundkörper von supraleitenden Filamenten und Stabilisierungsmaterial herstellbar ist. Hier wird dieses Verfahren angewendet, um ein besonders weiches Material zur Stabilisierung einsetzen zu können. Die erfindungsgemäße Aufgabe wird hierdurch nicht gelöst.

Durch die vorliegende Erfindung wird diese Aufgabe demgegenüber dadurch gelöst, daß der Verbundkörper nur einen Teil des endgültig vorgesehenen Stabilisierungsmaterials enthält und zunächst nur so weit verformt wird, daß er noch in Form einer geraden Stange vorliegt, daß er dann in ein Hüllrohr aus Stabilisierungsmaterial gesteckt und mit diesem weiter querschnittsvermindernd verformt wird, daß die Stäbe, die Kerne aus supraleitendem Material enthalten, bei der Bündelung um einen zentralen Bereich angeordnet sind, der nur Stabilisierungsmaterial enthält und daß der Querschnitt des zentralen Bereiches größer als 0.23 % des aus Verbundkörper und Hüllrohr gebildeten Gesamtquerschnittes ist.

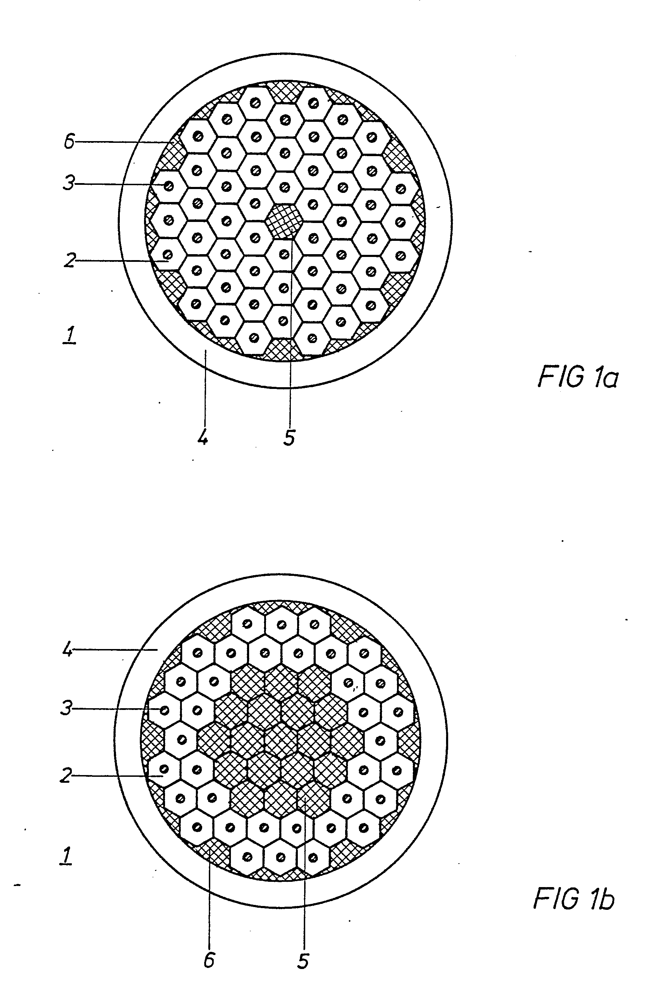

Die Erfindung soll anhand der Figuren 1 bis 4 und anhand von zwei durchgeführten Beispielen des Verfahrens näher erläutert werden.

Figur 1a zeigt einen Verbundkörper 1, der aus sechseckigen Stäben 2 aufgebaut ist, die jeweils einen Kern 3 aus Supraleitermaterial enthalten und die mit einem Mantel 4 aus Stabilisierungsmaterial (hier hockreines Kupfer) umgeben sind. Der mittlere Stab 5 besteht nur aus dem Stabilisierungsmaterial und enthält keinen Kern 3 aus Supraleitermaterial. Die Zwischenräume 6 zwischen den äußeren Stäben 2 und dem Mantel 4 sind in üblicher Weise durch Stabilisierungsmaterial aufgefüllt.

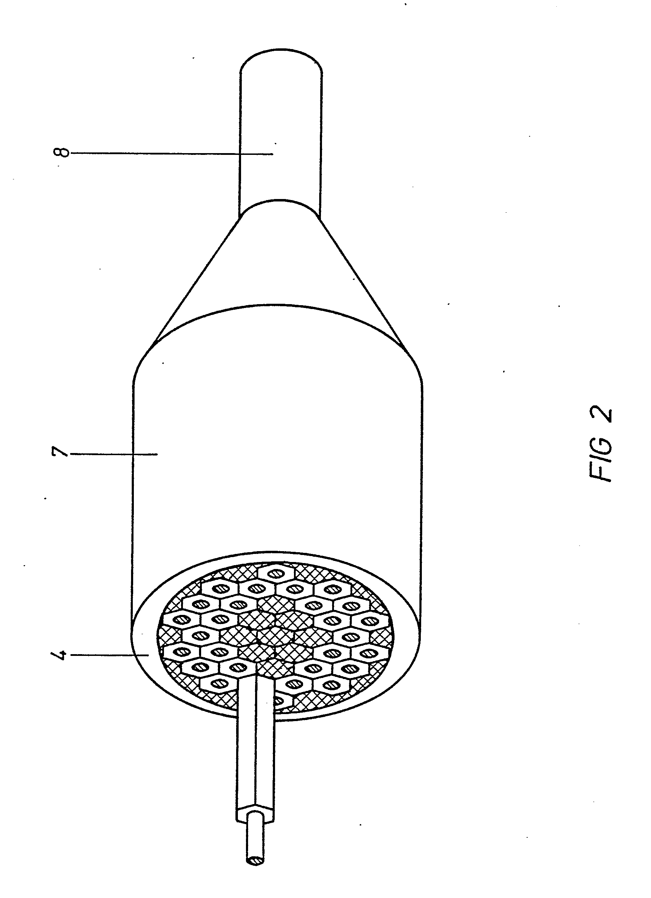

Außerdem wurde ein Verbundkörper 1 hergestellt, wie er in Figur 1b im Querschnitt dargestellt ist. Dieser ist ähnlich wie in Figur 1a aufgebaut, gleiche Teile sind mit gleichen Bezugszeichen versehen. Im Unterschied zu dem in Figur 1a dargestellten Querschnitt enthält der Verbundkörper 1 in Figur 1b eine größere Anzahl von Stäben 5, die nur aus dem Stabilisierungsmaterial (hier Kupfer) bestehen. Beide so aufgebauten Verbundkörper wurden dann, wie Figur 2 zeigt, zu einem Preßbolzen 7 verarbeitet, der in einer Strangpresse bei hohen Temperaturen von etwa 500°C zu einer Stange 8 verformt wurde. Dabei wurde der Außendurchmesser in beiden Fällen (Figur 1a und 1b) von 221 mm auf 60 mm verringert.

Die Stange 8 wurde dann durch mehrere Ziehvorgänge auf einen Außendurchmesser von 28,1 mm verformt.

Durch diese Verfahrensschritte entstand aus einem relativ kompakten Bolzen eine lange Stange, die bei weiteren querschnittsvermindernden Verformungen hätte aufgerollt werden müssen. Deshalb wurde die Stange in beiden Fällen in vier gleiche Teile geschnitten.

Man erhält bei einem Außendurchmesser von 28,1 mm vier Verbundkörper 1 in Form von Stangen mit einer Länge von je ca. 10 Metern. Jeder Verbundkörper 1 wurde -wie in Figur 3 dargestellt - in je ein Hüllrohr 10 aus Stabilisierungsmaterial gesteckt, dessen Länge kürzer war als die Länge des Verbundkörpers 1. Die nun entstandene Leiterkombination wurde dann durch weitere Ziehschritte verformt. Im Falle des in Fugur 1a dargestellten Bündels betrug der Außendurchmesser des Hüllrohres 10 73 mm und der Leiter, bestehend aus Verbundkörper 1 und Hüllrohr 10, wurde bis zu einem Außendurchmesser von 4 mm in ca. 20 Ziehschritten verformt. Bei diesem Außendurchmesser wurde festge stellt, daß einige Filamente durch die Ziehvorgänge bereits zerstört waren; damit war der Leiter unbrauchbar.

Im Falle des in Figur 1b dargestellten Verbundkörpers betrug der Außendurchmesser des Hüllrohres 65 mm. Dieser Außendurchmesser ist deshalb geringer als der Außendurchmesser des erstgenannten Hüllrohres, da ein größerer Anteil an Stabilisierungsmaterial im Verbundkörper 1 enthalten ist und in beiden Fällen das gleiche Verhältnis von Stabilisierungs-zu Supraleitermaterial (alpha = 13) eingestellt werden sollte. Auch diese Anordnung von Verbundkörper und Hüllrohr wurde durch weiteres Ziehen einer querschnittsvermindernden Verformung unterzogen.

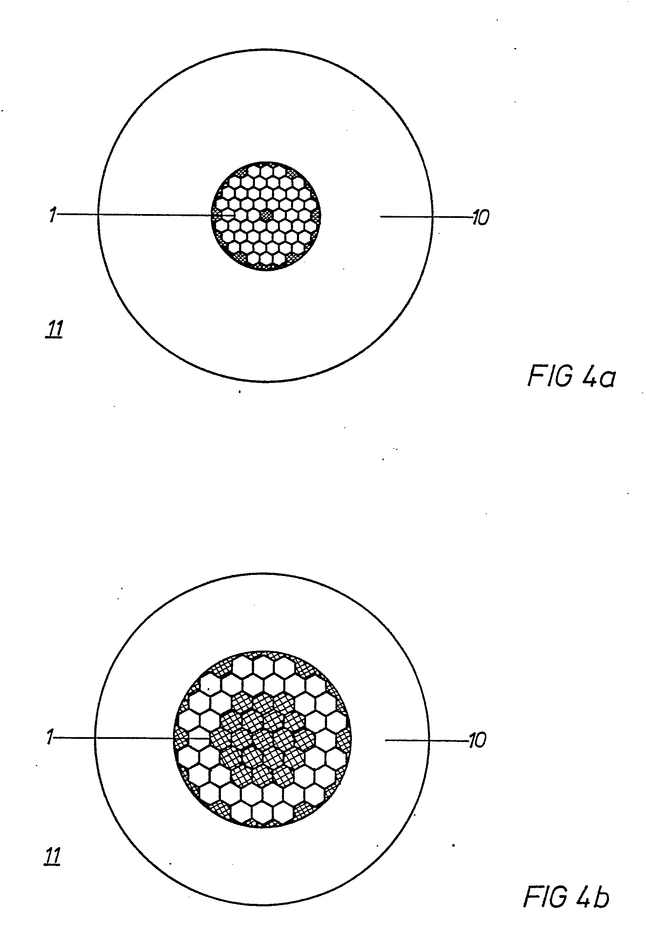

Die Figuren 4a und 4b zeigen die Querschnittsverhältnisse für beide Beispiele bei einem Außendurchmesser des aus Hüllrohr 10 und Verbundkörper 1 bestehenden Gesamtleiters 11. Dabei zeigt Figur 4a die aus dem in Figur 1a dargestellten Querschnitt entstandene Anordnung und in entsprechender Weise Figur 4b diejenige, die aus Figur 1b entstand. Ein Vergleich dieser Querschnitte läßt erkennen, daß der Querschnitt der einzelnen aus den Stäben 2 entstandenen Filamente in Figur 4b größer als in Figur 4a ist und daß sich in Zentrum des Querschnitts nach Figur 4b ein größerer Anteil an Stabilisierungsmaterial befindet als in Figur 4a. Berechnet man den Querschnitt des sich im Zentrum befindenden Stabilisierungsmaterials bezogen auf den Querschnitt des Gesamtleiters 11, so liegt dieses Ergebnis bei der Anordnung nach Figur 4a bei 0,23 % des Gesamtquerschnittes und im Falle der Anordnung nach Figur 4b bei 6,6 % des Gesamtquerschnittes. Der Leiter 11, nach Figur 4b, wurde bis auf die gewünschte Abmessung von 2 mm Außendurchmesser gezogen, ohne daß Filamentabrisse beobachtet wurden.

Diese Versuche beweisen die der vorliegenden Erfindung zugrundeliegende Lehre, daß sich ein Filament-Supraleiter mit hohem Anteil an Stabilisierungsmaterial herstellen läßt, wenn man nach den ersten Verformungsschritten den Verbundkörper 1 zusammen mit einem Hüllrohr 10 weiterverarbeitet und daß man Filamentabrisse dadurch vermeiden kann, indem man einen genügend großen zentralen Bereich, der nur Stabilisierungsmaterial enthält, vorsieht.

Die angegebenen Versuche zeigen, daß sich zur Fertigung von Supraleitern mit einem Anteil Stabilisierungsmaterial zu Supraleitermaterial von über 5:1 (z. B. 10:1 bis 15:1) und Filamentdurchmessern bis 40 $\mu$m im Zentrum des Verbundkörpers so viel Stabilisierungsmaterial befinden muß, daß dieser Querschnittsanteil gegenüber dem Gesamtquerschnitt mehr als 0,23 % beträgt.

**Ansprüche**

1. Verfahren zur Herstellung eines stabilisierten Filament-Supraleiters, bei dem Stäbe (2) mit je einem Kern (3) aus Supraleitermaterial gebündelt, mit einem Mantel (4) aus elektrisch gut leitfähigem Stabilisierungsmaterial umgeben und der so gebildete Verbundkörper (1) durch Strangpressen und/oder Ziehen einer querschnittsvermindernden Verformung unterzogen wird,
**dadurch gekennzeichnet,**
daß der Verbundkörper (1) nur einen Teil des endgültig vorgesehenen Stabilisierungsmaterials enthält und zunächst nur so weit verformt wird, daß er noch in Form einer geraden Stange (8) vorliegt,
daß er dann in ein Hüllrohr (10) aus Stabilisierungsmaterial gesteckt wird und mit diesem weiter querschnittsvermindernd verformt wird,
daß die Stäbe (2), die Kerne (3) aus supraleitendem Material enthalten, bei der Bündelung um einen zentralen Bereich angeordnet sind, der nur Stabilisierungsmaterial enthält und daß der Querschnitt des zentralen Bereichs größer als 0,23 % des aus Verbundkörper (1) und Hüllrohr (10) gebildeten Gesamtquerschnittes ist.

2. Verfahren nach Anspruch 1,
**dadurch gekennzeichnet,**
daß der Querschnitt des zentralen, aus Stabilisierungsmaterial bestehenden Bereichs, bezogen auf den aus Verbundkörper (1) und Hüllrohr (10) gebildeten Gesamtquerschnitt größer ist als 5 %, insbesondere 6,5 %.

3. Verfahren nach Anspruch 1,
**dadurch gekennzeichnet,**
daß beim Einführen des Verbundkörpers (1) in das Hüllrohr (10) die Länge des Verbundkörpers (1) größer ist als diejenige des Hüllrohres (10).

4. Verfahren nach Anspruch 1 oder 3,
**dadurch gekennzeichnet,**
daß der Verbundkörper (1) vor dem Einschieben in ein Hüllrohr (10) in mehrere Abschnitte geteilt wird.

5. Verfahren nach Anspruch 1,
**dadurch gekennzeichnet,**
daß als Stabilisierungsmaterial elektrisch gut leitfähiges Kupfer verwendet wird.

6. Verfahren nach Anspurch 1,
**dadurch gekennzeichnet,**
daß der zentrale Bereich aus Stabilisierungsmaterial durch Stäbe (5) gebildet wird, die den gleichen Querschnitt besitzen wie die das supraleitende Material enthaltenden Stäbe (2).

0 230 567

FIG 1a

FIG 1b

FIG 2

FIG 3

0 230 567

FIG 4a

FIG 4b

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 141 124 (ALSTHOM-ATLANTIQUE) * Zusammenfassung; Figur 1 * | 1,2 | H 01 L 39/14 |
| A | | 3-6 | |
| | --- | | |
| X | EP-A-0 156 626 (MAGNETIC CORP. OF AMERICA) * Spalte 7, Zeilen 4-27; Figur 3 * | 1,2 | |
| A | | 3-6 | |
| | --- | | |
| X | FR-A-2 305 830 (J. MALDY) * Anspruch 1; Figuren 1,2 * | 1,2 | RECHERCHIERTE SACHGEBIETE (Int. Cl.4) |
| A | | 3-6 | H 01 L 39 |
| | --- | | |
| X | FR-A-2 511 202 (J. DOSDAT) * Seite 10, Zeilen 8-15 * | 1,2 | |
| A | | 3-6 | |
| | ---     -/- | | |

Der vorliegende Recherchenbericht wurde für alle Patentansprüche erstellt.

| Recherchenort | Abschlußdatum der Recherche | Prüfer |
|---|---|---|
| DEN HAAG | 15-04-1987 | PELSERS L. |

**Europäisches Patentamt**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | BROWN BOVERI MITT., Band 62, Nr. 10/11, Oktober/November 1975, Seiten 490-495, Baden, CH; G. MEYER: "Supraleitende Kabel für Magnetspulen" * Insgesamt * | 1,2 | |
| A | IDEM | 3-6 | |
| | ----- | | |

RECHERCHIERTE SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 15-04-1987 | PELSERS L. |